# DEMANDE DE BREVET EUROPEEN

(11) **EP 2 282 329 A1**
(43) Date de publication de la demande: **09.02.2011**
(21) Numéro de dépôt: 10169721.7
(22) Date de dépôt: 15.07.2010
(51) Int. Cl.: H01L 21/60, H01L 23/485

(54) **Procédé de connexion électrique d'un fil de connexion à un plot de contact d'une puce de circuits intégrés et dispositif électronique correspondant.**

(30) Priorité: 27.07.2009 FR 0955237
(71) Demandeur: STMicroelectronics (Grenoble 2) SAS, 38000 Grenoble (FR)
(72) Inventeur: Coffy, Romain, 38950 Saint Martin Le Vinoux (FR); Quercia, Fabien, 38130 Echirolles (FR)
(74) Mandataire: Zapalowicz, Francis

(57) **Abrégé**

Procédé de connexion électrique d'un fil à un plot de connexion électrique d'une puce de circuits intégrés et dispositif électronique, dans lesquels un bloc intermédiaire d'interconnexion (4) électrique est interposé entre ledit plot de connexion électrique (3), une extrémité (7) du fil de connexion électrique (6).

## Description

La présente invention concerne le domaine des puces de circuits intégrés et des boîtiers comprenant de telles puces, et plus particulièrement les moyens filaires permettant de relier électriquement de telles puces à d'autres moyens ou dispositifs.

Il est proposé un procédé de connexion électrique d'un fil à un plot de connexion électrique d'une puce de circuits intégrés.

Un procédé de connexion électrique peut comprendre la mise en place d'un bloc intermédiaire d'interconnexion électrique sur ledit plot de connexion électrique et la mise en place d'une extrémité du fil de connexion électrique sur le bloc intermédiaire d'interconnexion.

Le procédé peut comprendre le choix, pour le bloc d'interconnexion, d'un matériau plus malléable ou ductile que celui du fil de connexion électrique et/ou du plot de connexion électrique.

Le procédé peut comprendre la formation d'une boule à l'extrémité d'un fil secondaire, la mise en place de cette boule sur le plot de connexion électrique en vue de la formation du bloc d'interconnexion et la rupture du fil secondaire en un endroit adjacent ou proche du bloc d'interconnexion.

Le procédé peut comprendre la formation d'une boule à l'extrémité du fil de connexion électrique et la mise en place de cette boule sur le bloc d'interconnexion.

Avant la mise en place de l'extrémité du fil de connexion électrique, le bloc d'interconnexion peut présenter une face frontale approximativement parallèle à celle du plot de connexion électrique.

Le bloc d'interconnexion peut être soudé sur le plot de connexion électrique.

Le fil de connexion électrique peut être soudé sur le bloc d'interconnexion.

Le plot de connexion électrique peut être choisi en aluminium, le bloc d'interconnexion peut être choisi en or et le fil de connexion électrique peut être choisi en cuivre, ou respectivement des alliages de tels matériaux.

Il est également proposé un dispositif électronique comprenant une puce de circuits intégrés comprenant au moins un plot de connexion électrique, un bloc intermédiaire d'interconnexion électrique soudé sur le plot de connexion électrique, et un fil de connexion électrique dont une extrémité est soudée sur le bloc d'interconnexion.

L'interface entre le bloc d'interconnexion et l'extrémité du fil de connexion électrique peut être approximativement parallèle à la face du plot de connexion électrique.

Le fil de connexion électrique peut comprendre une boule soudée sur le bloc d'interconnexion.

Le diamètre du bloc d'interconnexion et celui de l'extrémité du fil de connexion électrique peuvent être compris entre 1,5 et 3 fois le diamètre du fil de connexion électrique.

Le bloc d'interconnexion peut être en un matériau plus malléable ou ductile que celui du fil de connexion électrique et/ou du plot de connexion électrique.

Le plot peut être en aluminium ou un alliage à base d'aluminium, le bloc d'interconnexion peut être en or ou un alliage à base d'or et le fil de connexion électrique peut être en cuivre ou un alliage à base de cuivre.

Il est également proposé un boîtier électronique comprenant au moins un dispositif tel que celui ci-dessus.

Un dispositif électronique comprenant une puce de circuits intégrés et un fil de connexion électrique va maintenant être décrit à titre d'exemple non limitatif, illustré par le dessin sur lequel :
- la figure 1 représente une vue en élévation d'un dispositif électronique ;
- la figure 2 représente une première phase de montage de ce dispositif ;
- la figure 3 représente une seconde phase de montage de ce dispositif ;
- la figure 4 représente une troisième phase de montage de ce dispositif ;
- la figure 5 représente une quatrième phase de montage de ce dispositif ; et
- la figure 6 représente une cinquième phase de montage de ce dispositif.

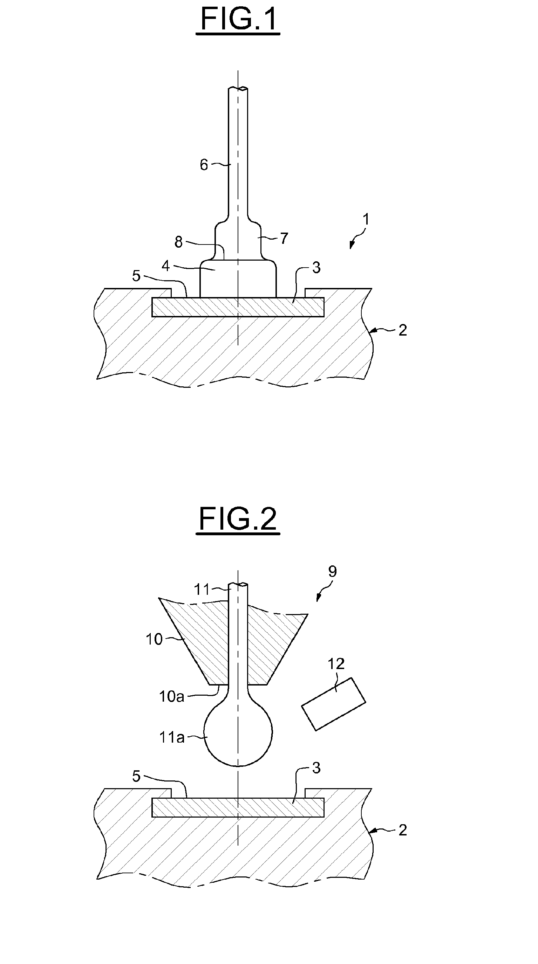

Un dispositif électronique 1, représenté sur la figure 1, comprend une puce de circuits intégrés 2 qui comprend une pluralité de plots de connexion électrique extérieure 3 en vue de réaliser des connexions de cette puce à d'autres moyens ou dispositifs.

Le dispositif semi-conducteur 1 comprend en outre, sur chaque plot 3, un bloc intermédiaire d'interconnexion électrique 4 soudé sur une face plate extérieure 5 du plot 3.

Le dispositif semi-conducteur 1 comprend également une pluralité de fils de connexion électrique 6, chaque fil 6 présentant une extrémité agrandie 7 soudée sur un bloc d'interconnexion 4.

L'interface 8 entre le bloc d'interconnexion électrique 4 et l'extrémité 7 du fil de connexion électrique 6 peut être approximativement parallèle à la face 5 du plot 3.

La liaison entre le bloc intermédiaire d'interconnexion 4 et le plot 3 et la liaison entre l'extrémité 7 du fil de connexion électrique 6 et le bloc intermédiaire d'interconnexion 4 peuvent être réalisées par une soudure eutectique.

Dans une première étape, le bloc intermédiaire d'interconnexion 4 peut être mis en place sur le plot 3, puis, dans une seconde étape, l'extrémité 7 du fil de connexion électrique 6 peut être mise en place sur le bloc intermédiaire d'interconnexion 4.

A titre d'exemple, ces mises en place peuvent être réalisées de la manière suivante.

Comme le montre la figure 2, un outil 9 peut présenter une tête 10 traversée par un fil secondaire 11 en une matière devant former le bloc d'interconnexion 4. Ce fil secondaire 11 dépassant vers le bas, un moyen 12 de l'outil 9, par exemple apte à générer un arc électrique de chauffage, permet la formation d'une boule 11a à l'extrémité du fil 11.

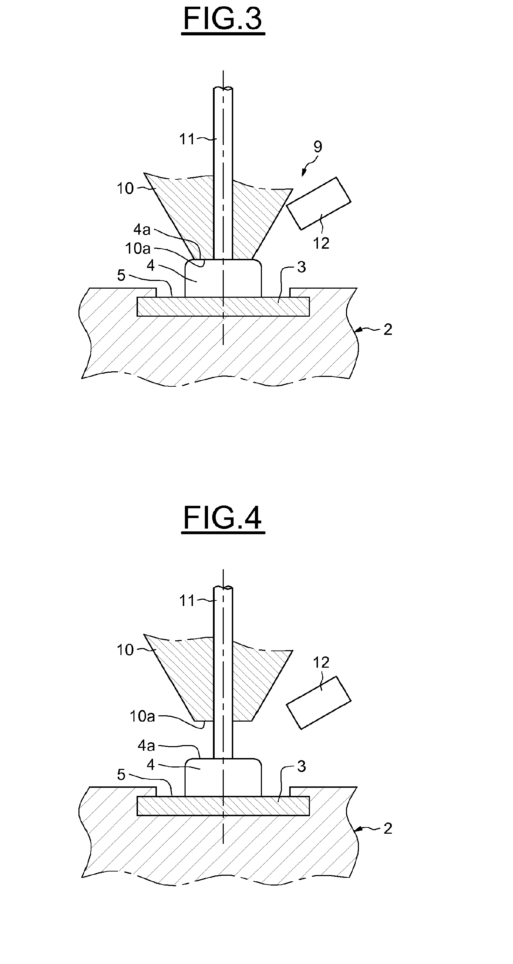

Comme le montre la figure 3, la tête 10 de l'outil 9 peut être déplacée vers le plot 3 de façon à écraser la boule 11a sur la surface 5 de ce plot 3 en exerçant une pression, légèrement mais suffisamment pour que la face avant annulaire 10a de la tête 10, parallèle à la face 5 du plot 3, s'applique sur la boule 11a pour former sur cette dernière une face 4a. Cette opération, qui peut être réalisée avec un apport de chaleur et éventuellement sous l'effet d'ultrasons, provoque une soudure ou une jonction eutectique du bloc d'interconnexion 4 sur le plot 3.

Après quoi, comme le montre la figure 4, la tête 10 peut être légèrement relevée, en glissant le long du fil secondaire 11, et le moyen 12 de l'outil 9 peut être activé pour générer un arc électrique de chauffage pour provoquer la rupture du fil secondaire 11 en un endroit adjacent ou proche du bloc d'interconnexion 4 formé, en éloignant la tête 10 de l'outil 9.

La boule 11a est ainsi transformée pour former le bloc d'interconnexion 4, qui prend approximativement la forme d'un cylindre ou d'un tronc de cône dont la grande base est sur le plot 3, la face frontale 4a du bloc d'interconnexion 4 étant approximativement parallèle à la face 5 du plot 3.

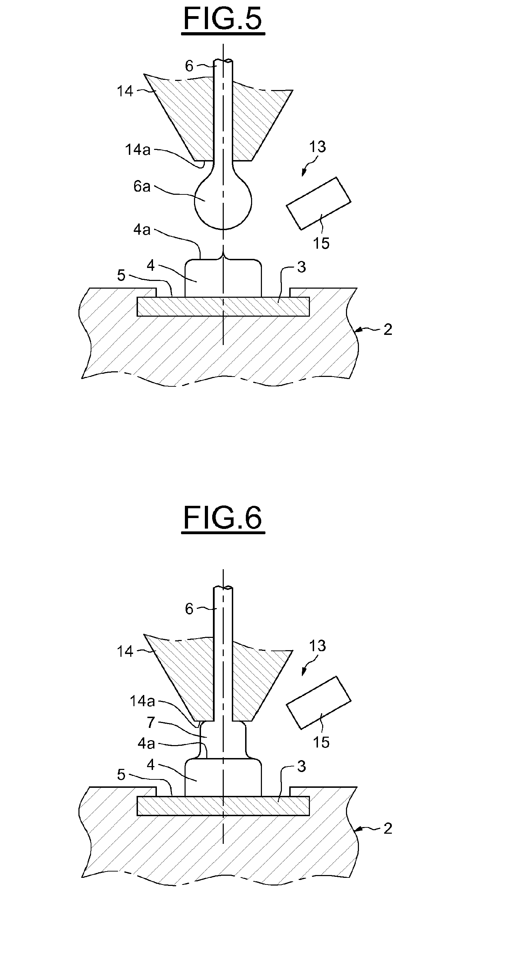

Ceci étant fait, comme le montre la figure 5, un outil 13 peut présenter une tête 14 traversée par un fil de connexion électrique 6. Ce fil de connexion électrique 6 dépassant vers le bas, un moyen 15 de l'outil 13, par exemple apte à générer un arc électrique de chauffage, permet la formation d'une boule 6a à l'extrémité du fil de connexion électrique 6. Cette boule 6a peut être plus petite que la boule 11a ayant servi à former le bloc d'interconnexion 4.

Comme le montre la figure 6, la tête 14 de l'outil 13 peut être déplacée vers le bloc d'interconnexion 4 formé, de façon à écraser la boule 6a sur la surface frontale 4a de ce bloc d'interconnexion 4 en exerçant une pression, légèrement mais suffisamment. Cette opération, qui peut être réalisée avec un apport de chaleur et éventuellement sous l'effet d'ultrasons, provoque une soudure ou une jonction eutectique de la boule 6a sur le bloc d'interconnexion, cette boule 6a formant alors l'extrémité agrandie 7.

Après quoi, la tête 14 de l'outil 13 peut être déplacée le long du fil de connexion électrique 6 et utilisée pour souder un autre endroit de ce fil sur un plot par exemple d'un autre moyen non représenté.

Les opérations ci-dessus peuvent être réalisées sur les autres blocs d'interconnexion 5 de la puce 2.

Le diamètre du fil secondaire 11 peut être plus grand que le diamètre du fil de connexion électrique 6. La boule 11a se formant à l'extrémité du fil secondaire 11 peut être plus grosse que la boule 6a se formant à l'extrémité du fil de connexion électrique 6. Cela peut permettre que l'extrémité agrandie 7 du fil de connexion 6 soit bien formée sur le bloc d'interconnexion 4. Le diamètre du fil secondaire 11 peut être égal ou plus grand que le diamètre du fil de connexion électrique 6.

Il résulte de ce qui précède que, de prévoir entre le plot 3 de la puce de circuits intégrés 2 et le fil de connexion électrique 6, un bloc d'interconnexion 4, permet de choisir, pour former le plot 3 et le fil de connexion 6, des matériaux qui, normalement, ne permettent pas une liaison directe résistante et stable entre eux.

Il est en effet rendu possible de choisir, pour le plot 3 et le bloc d'interconnexion 4, des matériaux aptes à créer une liaison résistante et stable entre eux, et, pour former le bloc d'interconnexion 4 et le fil de connexion 6, également des matériaux aptes à créer une liaison résistante et stable entre eux.

Par ailleurs, il est en outre rendu possible de choisir, pour le bloc d'interconnexion 4, un matériau plus malléable ou ductile que celui du plot 3 et/ou du fil de connexion électrique 6. Cela permet de limiter les contraintes de pression sur la puce 2.

En outre, le pas entre des plots de connexion électrique 3 d'une puce 2 peut être réduit.

A titre d'exemples, le plot de connexion électrique 3 peut être en aluminium, le bloc d'interconnexion électrique 4 peut être en or et le fil de connexion électrique 6 peut être en cuivre. Des alliages peuvent aussi convenir. L'existence d'un bloc d'interconnexion électrique en or permet de s'affranchir des difficultés liées à une soudure directe d'un fil de connexion électrique en cuivre sur un plot de connexion électrique en aluminium.

Selon un exemple de réalisation, le diamètre du bloc d'interconnexion 4 et le diamètre de l'extrémité 7 du fil de connexion électrique 6 peuvent être approximativement compris entre 1,5 et 3 fois le diamètre courant du fil de connexion électrique 6. Le diamètre du bloc d'interconnexion 4 peut être plus petit que le diamètre de l'extrémité 7 du fil de connexion électrique 6. La hauteur du bloc d'interconnexion 4 et la hauteur de l'extrémité 7 du fil de connexion électrique 6 peuvent être approximativement comprises entre 0,75 et 2 fois le diamètre courant du fil de connexion électrique 6.

En particulier, le diamètre courant du fil de connexion électrique 6 peut être compris entre 20 et 25 microns, le diamètre du bloc d'interconnexion 4 peut être compris entre 40 et 45 microns, la hauteur du bloc d'interconnexion 4 peut être comprise entre 20 et 25 microns, le diamètre de l'extrémité 7 du fil de connexion électrique 6 peut être compris entre 35 et 40 microns.

## Revendications

1. Procédé de connexion électrique d'un fil à un plot de connexion électrique d'une puce de circuits intégrés, comprenant :
la mise en place d'un bloc intermédiaire d'interconnexion (4) électrique sur ledit plot de connexion électrique (3), et
la mise en place d'une extrémité (7) du fil de connexion électrique (6) sur le bloc intermédiaire d'interconnexion (4).

2. Procédé selon la revendication 1, comprenant le choix, pour le bloc d'interconnexion (4), d'un matériau plus malléable ou ductile que celui du fil de connexion électrique (6) et/ou du plot de connexion électrique (3).

3. Procédé selon l'une des revendications 1 et 2, comprenant la formation d'une boule (11a) à l'extrémité d'un fil secondaire (11), la mise en place de cette boule sur le plot de connexion électrique (3) en vue de la formation du bloc d'interconnexion (4) et la rupture du fil secondaire (11) en un endroit adjacent ou proche du bloc d'interconnexion (4).

4. Procédé selon l'une quelconque des revendications précédentes, comprenant la formation d'une boule (6a) à l'extrémité du fil de connexion électrique (6) et la mise en place de cette boule sur le bloc d'interconnexion (4).

5. Procédé selon l'une quelconque des revendications précédentes, dans lequel, avant la mise en place de l'extrémité du fil de connexion électrique, le bloc d'interconnexion présente une face frontale (4a) approximativement parallèle à celle du plot de connexion électrique (3).

6. Procédé selon l'une quelconque des revendications précédentes, dans lequel le bloc d'interconnexion (4) est soudé sur le plot de connexion électrique (3).

7. Procédé selon l'une quelconque des revendications précédentes, dans lequel le fil de connexion électrique (6) est soudé sur le bloc d'interconnexion (4).

8. Procédé selon l'une quelconque des revendications précédentes, dans lequel le plot de connexion électrique (3) est choisi en aluminium, le bloc d'interconnexion (4) est choisi en or et le fil de connexion électrique (6) est choisi en cuivre.

9. Dispositif électronique comprenant :
une puce de circuits intégrés (2) comprenant au moins un plot de connexion électrique (3),
un bloc intermédiaire d'interconnexion électrique (4) soudé sur le plot de connexion électrique (3),
et un fil de connexion électrique (6) dont une extrémité est soudée sur le bloc d'interconnexion(4).

10. Dispositif selon la revendication 9, dans lequel l'interface (8) entre le bloc d'interconnexion (4) et l'extrémité (7) du fil de connexion électrique (6) est approximativement parallèle à la face (5) du plot de connexion électrique (3).

11. Dispositif selon l'une des revendications 9 et 10, dans lequel le fil de connexion électrique (6) comprend une boule (7) soudée sur le bloc d'interconnexion (4).

12. Dispositif selon l'une quelconque des revendications 9 à 11, dans lequel le diamètre du bloc d'interconnexion et celui de l'extrémité du fil de connexion électrique sont compris entre 1,5 et 3 fois le diamètre du fil de connexion électrique.

13. Dispositif selon l'une quelconque des revendications 9 à 12, dans lequel le bloc d'interconnexion (4) est en un matériau plus malléable ou ductile que celui du fil de connexion électrique (6) et/ou du plot de connexion électrique (3).

14. Dispositif selon l'une quelconque des revendications 9 à 13, dans lequel le plot est en aluminium ou un alliage à base d'aluminium, le bloc d'interconnexion est en or ou un alliage à base d'or et le fil de connexion électrique est en cuivre ou un alliage à base de cuivre.

15. Boîtier électronique comprenant au moins un dispositif selon l'une quelconque des revendications 9 à 14.
